# EUROPEAN PATENT APPLICATION

(11) **EP 4 561 096 A1**
(43) Date of publication of application: **28.05.2025**
(21) Application number: 23854114.8
(22) Date of filing: 29.06.2023
(51) Int. Cl.: H04R 1/08, H04N 19/00, H04R 1/14, H03G 5/02

(54) **BONE CONDUCTION MICROPHONE**

(30) Priority: 17.08.2022 CN 202210989439
(71) Applicant: Huawei Technologies Co., Ltd., Shenzhen, Guangdong 518129 (CN)
(72) Inventor: YANG, Hui, Shenzhen, Guangdong 518129 (CN); ZHANG, Libin, Shenzhen, Guangdong 518129 (CN); YANG, Zhihua, Shenzhen, Guangdong 518129 (CN)
(74) Representative: MERH-IP Matias Erny Reichl Hoffmann Patentanwälte PartG mbB
(86) International application number: PCT/CN2023/103710
(87) International publication number: WO 2024/037209

(57) **Abstract**

Embodiments of this application disclose a bone conduction microphone, a headphone, and a communication apparatus, and may be applied to a scenario of making a call with a remote peer party through wireless communication. Especially when ambient noise is high, the bone conduction microphone has good noise reduction effect, and can improve a signal-to-noise ratio of a signal captured by the bone conduction microphone. The bone conduction microphone includes a sound pickup, a vibration obtaining component, and a noise reduction component. The noise reduction component includes a first dielectric layer and a second dielectric layer that are stacked. The first dielectric layer and the second dielectric layer are made of elastic materials, and cover another surface of the sound pickup other than a sound pickup surface, and an opening is disposed at one end corresponding to the sound pickup surface. The vibration obtaining component includes a third dielectric layer. The third dielectric layer is disposed at a layer of the sound pickup close to the sound pickup surface, and seals the opening end of the first dielectric layer. A contact surface between the first dielectric layer and the second dielectric layer is a rough contact surface.

## Description

### TECHNICAL FIELD

This application relates to the sensor field, and in particular, to a bone conduction microphone, a bone conduction headphone, and a call apparatus.

### BACKGROUND

In a high noise scenario, a microphone based on air conduction is drowned out in ambient noise, and consequently, cannot effectively capture a user voice. This greatly affects user call experience. For example, in various industrial noise scenarios, industrial noise is usually greater than 80 decibels, and sometimes even greater than 120 decibels. In normal cases, human voice is about 70 decibels, and is completely drowned out in the ambient noise. Therefore, a bone conduction microphone is used in many high-noise scenarios, to capture a vibration signal that is produced by a mouth or a throat of a person and that is transmitted to the bone conduction microphone through skin, muscles, and bones, to improve a signal-to-noise ratio of a wanted signal in a high-noise environment.

However, in actual use, external noise is also propagated to the bone conduction microphone in a form of vibration. If interference of the noise vibration cannot be effectively eliminated, use effect of the bone conduction microphone is greatly affected. Therefore, how to reduce impact of external noise on the bone conduction microphone and improve a signal-to-noise ratio of the bone conduction microphone becomes an urgent problem to be resolved.

### SUMMARY

Embodiments of this application provide a bone conduction microphone. A structure of the bone conduction microphone is designed, to reduce impact of external noise on the bone conduction microphone, and improve a signal-to-noise ratio of a signal captured by the bone conduction microphone.

In view of this, embodiments of this application provide the following technical solutions.

According to a first aspect, an embodiment of this application first provides a bone conduction microphone, which may be applied to a high-noise environment to capture vibration of vocal cords of a user, to propagate a signal. The bone conduction microphone includes a sound pickup, a vibration obtaining component, and a noise reduction component. The noise reduction component includes at least two dielectric layers. The at least two dielectric layers include a first dielectric layer and a second dielectric layer. Both the first dielectric layer and the second dielectric layer are made of elastic materials. The first dielectric layer is fastened on the sound pickup and covers another surface of the sound pickup other than a sound pickup surface. The first dielectric layer is provided with an opening at an end corresponding to the sound pickup surface. The second dielectric layer is fastened on a side that is of the first dielectric layer and that is away from the sound pickup, and covers another surface of the first dielectric layer other than the opening end.

The first dielectric layer may be closely attached to the another surface of the sound pickup other than the sound pickup surface, or there may be some gaps between the first dielectric layer and the another surface of the sound pickup. A surface that is of the first dielectric layer and that is in contact with the second dielectric layer is a rough surface, or a surface that is of the second dielectric layer and that is in contact with the first dielectric layer is a rough surface. That is, there are some gaps between the second dielectric layer and the first dielectric layer.

The vibration obtaining component includes a third dielectric layer, the third dielectric layer is disposed on a side of the sound pickup close to the sound pickup surface, and the opening end of the first dielectric layer is sealed with the third dielectric layer.

The vibration obtaining component is configured to touch a human body to obtain vocal cord vibration, and the noise reduction component is configured to absorb vibration in another direction other than the sound pickup surface.

According to the bone conduction microphone provided in this embodiment of this application, the plurality of dielectric layers are disposed, and vibration that is propagated by external noise to the sound pickup is absorbed by the elastic dielectric layers, to achieve good noise reduction effect. In addition, a contact surface between the first dielectric layer and the second dielectric layer is set as a rough surface. In this way, an air spacing can be added between the dielectric layers, and an energy loss between the plurality of layers of elastic materials is increased by using the air spacing, to further reduce external noise vibration propagated to a surface of the sound pickup. In addition, roughness of a contact surface of the elastic materials is increased, so that vibration generated by friction between the dielectric layers can be reduced, and impact of the plurality of dielectric layers on a sound pickup effect can be reduced.

In a possible implementation, a periphery of the third dielectric layer is in close contact with the first dielectric layer to seal the opening end of the first dielectric layer, and an edge that is of the first dielectric layer and that corresponds to the opening end and an edge that is of the second dielectric layer and that corresponds to the opening end exceed the third dielectric layer in a direction perpendicular to the third dielectric layer.

Both the first dielectric layer and the second dielectric layer are made of elastic materials. When in contact with human skin, the first dielectric layer and the second dielectric layer undergo elastic deformation corresponding to an elastic modulus due to pressing by the human skin. In this way, the first dielectric layer and the second dielectric layer are more closely attached to user skin through an acting force of the elastic deformation. This can prevent external noise from being propagated to the sound pickup through a gap between the bone conduction microphone and the user skin, and also prevent noise caused by friction between the bone conduction microphone and a surface of the user skin due to movement of the bone conduction microphone.

In a possible implementation, a ratio of ΔL₁/L₁ to ΔL₂/L₂ is inversely proportional to a ratio of E₁ to E₂, where E₁ is an elastic modulus of the first dielectric layer, E₂ is an elastic modulus of the second dielectric layer, ΔL₁ is a length by which the edge that is of the first dielectric layer and that corresponds to the opening end exceeds the third dielectric layer in the direction perpendicular to the third dielectric layer, ΔL₂ is a length by which the edge that is of the second dielectric layer and that corresponds to the opening end exceeds the third dielectric layer in the direction perpendicular to the third dielectric layer, L₁ is a total length of the first dielectric layer in the direction perpendicular to the third dielectric layer, and L₂ is a total length of the second dielectric layer in the direction perpendicular to the third dielectric layer.

When a same magnitude of acting force is applied to two different dielectric layers, a dielectric layer with a larger elastic modulus undergoes greater elastic deformation than a dielectric layer with a smaller elastic modulus. Therefore, the foregoing design can further ensure that each dielectric layer is closely attached to the user skin. This can prevent external noise from being propagated to the sound pickup through a gap between the bone conduction microphone and the user skin, and also prevent noise caused by friction between the bone conduction microphone and a surface of the user skin due to movement of the bone conduction microphone.

In a possible implementation, roughness of a surface may be measured by a spacing between micro textures on the surface. A spacing between micro textures on the surface that is of the first dielectric layer and that is in contact with the second dielectric layer is greater than a first threshold, or a spacing between micro textures on the surface that is of the second dielectric layer and that is in contact with the first dielectric layer is greater than the first threshold.

In a possible implementation, the first threshold may be 1 mm, 2 mm, or 5 mm.

In a possible implementation, the noise reduction component includes a plurality of dielectric layers, and elastic moduli of materials of the plurality of dielectric layers sequentially increase from a direction close to the sound pickup to a direction away from the sound pickup.

This setting has two advantages. First, a larger elastic modulus of a material indicates a better noise absorption effect of the material. Therefore, when some noise vibration reaches an inner dielectric layer (for example, the first dielectric layer) through an outer dielectric layer (for example, the second dielectric layer), the inner dielectric layer can better attenuate noise vibration that cannot be absorbed by the outer dielectric layer. Second, generally, a larger elastic modulus of a material indicates a softer material. Therefore, the inner dielectric layer is softer than the outer dielectric layer, and can protect the sound pickup well.

In a possible implementation, an elastic modulus of an outermost dielectric layer of the plurality of dielectric layers included in the noise reduction component is less than a second threshold. For example, the second threshold may be 5 GPa.

The elastic modulus of the outermost dielectric layer is less than the second threshold, so that it can be ensured that the outermost dielectric layer has specific hardness, to better protect the sound pickup and the entire bone conduction microphone.

In a possible implementation, the first dielectric layer is closely attached to the another surface of the sound pickup other than the sound pickup surface.

The first dielectric layer is closely attached to the sound pickup. This maintains stability of a connection between the first dielectric layer and the sound pickup, and improves reliability of the entire bone conduction microphone. In addition, a design in which the first dielectric layer 21 is closely attached to the sound pickup 3 is easier to implement in engineering, and is conducive to productization of the bone conduction microphone.

In a possible implementation, the third dielectric layer is closely attached to the sound pickup surface.

The third dielectric layer is closely attached to the sound pickup surface. In this way, vibration can be propagated to the sound pickup surface with maximum efficiency, and vibration capture efficiency is improved. In addition, the bone conduction microphone is designed to be more miniaturized, and this helps beautify an overall design of the bone conduction microphone.

In a possible implementation, the noise reduction component is provided with a lead port, for leading out a signal cable of the sound pickup.

In a possible implementation, the sound pickup is a capacitive sensor.

According to a second aspect, an embodiment of this application further provides a bone conduction headphone, including the bone conduction microphone described in the first aspect and a speaker.

According to a third aspect, an embodiment of this application further provides a head-mounted device, including the bone conduction headphone described in the second aspect and a device body. The device body includes glasses or a helmet.

According to a fourth aspect, an embodiment of this application further provides a fairy tale apparatus, including the bone conduction microphone described in the first aspect and a transceiver. The transceiver is connected to the bone conduction microphone, and communicates with an external device.

The second aspect to the fourth aspect of embodiments of this application can implement the beneficial effects described in the first aspect. To avoid repetition, details are not described herein again.

### BRIEF DESCRIPTION OF DRAWINGS

FIG. 1 is a diagram of a use manner of a bone conduction microphone according to an embodiment of this application;
FIG. 2 is a diagram of a structure of a bone conduction microphone according to an embodiment of this application;
FIG. 3 is a diagram of a structure of another bone conduction microphone according to an embodiment of this application;
FIG. 4 is a diagram of a structure of another bone conduction microphone according to an embodiment of this application;
FIG. 5 is a diagram of a structure of another bone conduction microphone according to an embodiment of this application;
FIG. 6 is a diagram of a structure of another bone conduction microphone according to an embodiment of this application; and
FIG. 7 is a diagram of a structure of a bone conduction headphone according to an embodiment of this application.

### DESCRIPTION OF EMBODIMENTS

The following describes embodiments of the present invention with reference to the accompanying drawings in embodiments of the present invention. The following descriptions show drawings showing specific aspects of embodiments of the present invention or specific aspects of embodiments of the present invention that may be used. It should be understood that embodiments of the present invention may be used in other aspects, and may include structural or logical changes not depicted in the accompanying drawings. The following detailed description, therefore, is not to be taken in a limiting sense, and the scope of the present invention is defined by the appended claims. For example, it should be understood that the disclosure with reference to the described method may also be applied to a corresponding device or system for performing the method, and vice versa. For example, if one or more specific method steps are described, a corresponding device may include one or more units such as functional units for performing the described one or more method steps (for example, one unit performs the one or more steps; or a plurality of units, each of which performs one or more of the plurality of steps), even if such one or more units are not explicitly described or illustrated in the accompanying drawings. In addition, for example, if a specific apparatus is described based on one or more units such as a functional unit, a corresponding method may include one step for implementing functionality of one or more units (for example, one step for implementing functionality of one or more units; or a plurality of steps, each of which is for implementing functionality of one or more units in a plurality of units), even if such one or more of steps are not explicitly described or illustrated in the accompanying drawings. Further, it should be understood that features of example embodiments and/or aspects described in this specification may be combined with each other, unless expressly stated otherwise.

In embodiments of the present invention, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one item (piece) of the following" or a similar expression thereof means any combination of these items, including a singular item (piece) or any combination of plural items (pieces). For example, at least one of a, b, or c may indicate: a; b; c; a and b; a and c; b and c; or a, b, and c; where a, b, and c may be singular or plural.
Terms used in implementations of the present invention are merely intended to explain specific embodiments of the present invention, and are not intended to limit the present invention.
Terms explanation
   1. Surface roughness (Surface Roughness)
      The surface roughness may be understood as unevenness of fine spacings and small peaks and valleys in a product processing process, and is usually defined as a smile distance between two peaks or two valleys. A peak or valley is also referred to as a micro texture. Therefore, the surface roughness may be measured by a spacing between micro textures.
   2. Elastic modulus (Elastic Modulus)
Generally, when an external acting force is applied to an elastomer, the elastomer undergoes a change in shape (this is referred to as "deformation"). The "elastic modulus" is generally defined as follows: Stress in a uniaxial stress condition divided by strain in this direction. In an elastic deformation phase, stress and strain of a material should be in direct proportion (that is, follow the Hooke's law), and a proportional coefficient is referred to as an elastic modulus. The elastic modulus is a physical quantity that describes elasticity of a material, and is a general term. The elastic modulus may be represented by "Yang's modulus", "shear modulus", "bulk modulus", or the like.
First, an application scenario related to a bone conduction microphone provided in embodiments of this application is described. The bone conduction microphone provided in embodiments of this application may be used in various scenarios of making a call with a remote peer party through wireless communication. Particularly, the bone conduction microphone provided in embodiments of this application may capture vocal cord vibration produced by a human body in a high-noise environment, and convert the vocal cord vibration into an electrical signal for transmission. In a possible implementation, a part of the bone conduction microphone may be pushed against a jaw, a throat, or the like, to obtain, through bone conduction, vocal cord vibration produced by a human body.

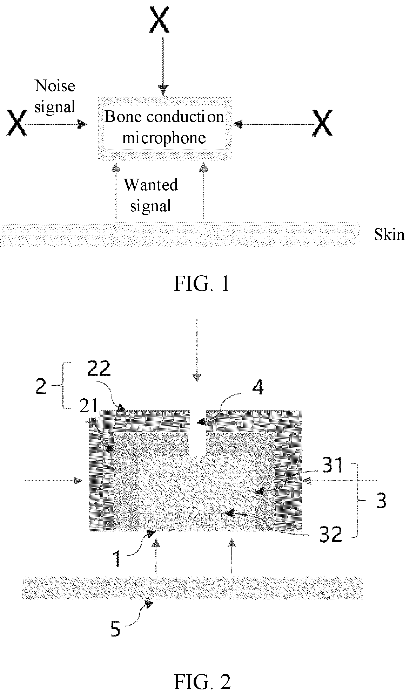

FIG. 1 is a diagram of a use manner of a bone conduction microphone according to an embodiment of this application. As shown in FIG. 1, a sound pickup surface of the bone conduction microphone is configured to capture a vibration signal from skin of a human body, convert the vibration signal into an electrical signal in form, and transmit the electrical signal through wireless communication. However, in actual use, a noise signal in an environment is propagated to the bone conduction microphone through vibration. Therefore, in addition to capturing wanted vibration signals from the skin, the bone conduction microphone also captures noise signals propagated to the bone conduction microphone from other directions. These noise signals cause a large quantity of noise signals in electrical signals obtained by the bone conduction microphone after capturing, and cause great interference to normal use of the bone conduction microphone.

For a noise problem in the bone conduction microphone, an embodiment of this application provides a bone conduction microphone with a good noise reduction effect. For details, refer to FIG. 2. FIG. 2 is a diagram of a structure of a bone conduction microphone according to an embodiment of this application. As shown in FIG. 2, the bone conduction microphone provided in this embodiment of this application includes a vibration obtaining component 1, a noise reduction component 2, and a sound pickup 3.

The sound pickup 3 includes a sound pickup surface 32 and another surface 31 other than the sound pickup surface 32. For example, the sound pickup may be a hexahedron including six surfaces. One surface is a sound pickup surface 32 (it is assumed that the bottom surface is the sound pickup surface), and the other five surfaces are other surfaces 31 (in this case, the top surface and the four side surfaces are the other surfaces). The sound pickup surface 32 is configured to contact human skin 5 to capture vibration on the human skin, and the another surface 31 is generally not in contact with the human skin.

The sound pickup 3 may be in a common microphone form such as a carbon granule microphone, an electromagnetic microphone, a condenser microphone (electret condenser microphone), a piezoelectric crystal microphone, a piezoelectric ceramic microphone, or a silicon dioxide microphone. This is not limited in this embodiment of this application.

The noise reduction component 2 includes at least two dielectric layers. For example, the noise reduction component 2 may include a first dielectric layer 21 and a second dielectric layer 22. The first dielectric layer 21 and the second dielectric layer 22 may be made of elastic materials. The first dielectric layer 21 is fastened on the sound pickup 3, the first dielectric layer 21 covers the another surface 32 of the sound pickup 3 other than the sound pickup surface 31, and the first dielectric layer 21 is provided with an opening at an end corresponding to the sound pickup surface 31 of the sound pickup 3. In a possible implementation, an elastic modulus of the first dielectric layer 21 may be less than 0.1 GPa.

The noise reduction component 2 is configured to absorb vibration in another direction other than the sound pickup surface. It should be understood that the noise reduction component 2 may further include another dielectric layer other than the first dielectric layer 21 and the second dielectric layer 22. For example, one or more dielectric layers may further be disposed outside the second dielectric layer 22, to better attenuate ambient noise vibration. A quantity of dielectric layers included in the noise reduction component 2 is not limited in this embodiment of this application. Theoretically, a larger quantity of dielectric layers included in the noise reduction component 2 indicates better overall noise reduction effect of the noise reduction component. The following embodiment is described mainly by using an example in which the noise reduction component 2 includes two dielectric layers: the first dielectric layer 21 and the second dielectric layer 22.

The first dielectric layer 21 and the second dielectric layer 22 that are made of the elastic materials cover the another surface 31 of the sound pickup 3, so that transmission of external noise vibration can be attenuated to some extent, vibration propagated to the another surface 31 of the sound pickup is reduced, and a signal-to-noise ratio is improved.

The first dielectric layer 21 may be fastened on the sound pickup 3 in various manners. In a possible implementation, the first dielectric layer 21 may be closely attached to the sound pickup 3, to closely attach the first dielectric layer 21 to the sound pickup 3. This maintains stability of a connection between the first dielectric layer 21 and the sound pickup 3, improves reliability of the entire bone conduction microphone, facilitates a design of the bone conduction microphone to be more miniaturized, and helps beautify an overall design of the bone conduction microphone. In addition, a design in which the first dielectric layer 21 is closely attached to the sound pickup 3 is easier to implement in engineering, and is conducive to productization of the bone conduction microphone.

In another possible implementation, there may be a spacing between the first dielectric layer 21 and the sound pickup, and the spacing may be an air spacing or a vacuum spacing. For example, the first dielectric layer 21 may be fastened on the sound pickup 3 at two ends, and another part is kept at a specific spacing from the sound pickup; or a contact surface between the first dielectric layer 21 and the sound pickup 3 may be a rough surface. A specific vacuum spacing is set between the first dielectric 21 and the sound pickup 3, so that vibration caused by noise can be further blocked by the vacuum, to improve a noise reduction effect.

The second dielectric layer 22 is fastened on a side that is of the first dielectric layer 21 and that is away from the sound pickup 3, and the second dielectric layer 22 covers another surface of the first dielectric layer 21 other than the opening end.

In a possible implementation, elastic moduli of materials of the plurality of dielectric layers included in the noise reduction component 2 sequentially increase from a direction close to the sound pickup 3 to a direction away from the sound pickup 3. This setting has two advantages. First, a larger elastic modulus of a material indicates greater attenuation of vibration during transmission through the material, that is, a better noise absorption effect of the material. Therefore, when some noise vibration reaches an inner dielectric layer (for example, the first dielectric layer 21) through an outer dielectric layer (for example, the second dielectric layer 22), the inner dielectric layer can better attenuate noise vibration that cannot be absorbed by the outer dielectric layer. Second, generally, a larger elastic modulus of a material indicates a softer material. Therefore, the inner dielectric layer is softer than the outer dielectric layer, and can protect the sound pickup 3 well.

In a possible implementation, an elastic modulus of an outermost dielectric layer of the at least two dielectric layers included in the noise reduction component 2 is less than a second threshold. For example, the second threshold may be 5 GPa. The elastic modulus of the outermost dielectric layer is less than the second threshold, so that it can be ensured that the outermost dielectric layer has specific hardness, to better protect the sound pickup and the entire bone conduction microphone.

The vibration obtaining component 1 is disposed at the opening of the first dielectric layer 21 and an opening of the second dielectric layer 22, to obtain vibration from a surface of a human skin. The vibration obtaining component 1 includes a third dielectric layer. The third dielectric layer is disposed on a side that is of the sound pickup 3 and that is close to the sound pickup surface 32, and the third dielectric layer is configured to touch a human body to obtain vocal cord vibration. The opening end of the first dielectric layer 21 is sealed with the third dielectric layer. In a possible implementation, an elastic modulus of the third dielectric layer may be less than 0.1 GPa.

It should be understood that, in addition to the third dielectric layer, the obtaining component 1 may further include another structure. For example, the obtaining component 1 may further include another dielectric layer. This is not limited in this embodiment of this application.

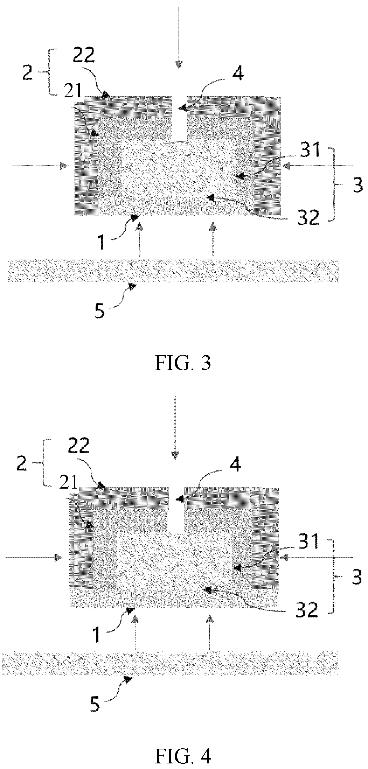

In a possible implementation, as shown in FIG. 2, the obtaining component 1 may be connected to an inner side of the first dielectric layer 21, to seal the opening end of the first dielectric layer 21. In another possible implementation, as shown in FIG. 3, the obtaining component 1 may be connected to an end side of the opening end of the first dielectric layer 21, and connected to an inner side of the second dielectric layer 22, to seal the opening end of the first dielectric layer 21 and the opening end of the second dielectric layer 22. In another possible implementation, as shown in FIG. 4, the obtaining component 1 may be connected to the end side of the opening end of the first dielectric layer 21 and an end side of the opening end of the second dielectric layer 22, to seal the opening end of the first dielectric layer 21 and the opening end of the second dielectric layer 22. It should be understood that the foregoing descriptions of the manners of coupling between the obtaining component 1 and each the first dielectric layer 21 and the second dielectric layer 22 are merely examples, and another coupling manner is also possible. For example, when the obtaining component 1 includes a plurality of dielectric layers or the obtaining component is thick, the obtaining component may be connected to the inner side of the first dielectric layer 21 and/or the end side of the opening end of the first dielectric layer 21 and/or the inner side of the second dielectric layer 22 and/or the end side of the opening end of the second dielectric layer 22.

In a possible implementation, the third dielectric layer is closely attached to the sound pickup surface 32 of the sound pickup 3. The third dielectric layer is closely attached to the sound pickup surface 32. In this way, vibration can be propagated to the sound pickup surface with maximum efficiency, and vibration capture efficiency is improved. In addition, the bone conduction microphone is designed to be more miniaturized, and this helps beautify an overall design of the bone conduction microphone.

In a possible implementation, the noise reduction component 2 is provided with a lead port 4, for leading out a signal cable of the sound pickup 3. It should be understood that a position of the lead port 4 in FIG. 2 is merely an example. A specific position of the lead port 4 is not limited in this embodiment of this application. For example, the lead port 4 may be located on a left half of the noise reduction component 2, or the lead port 4 may be located on a right half of the noise reduction component 2.

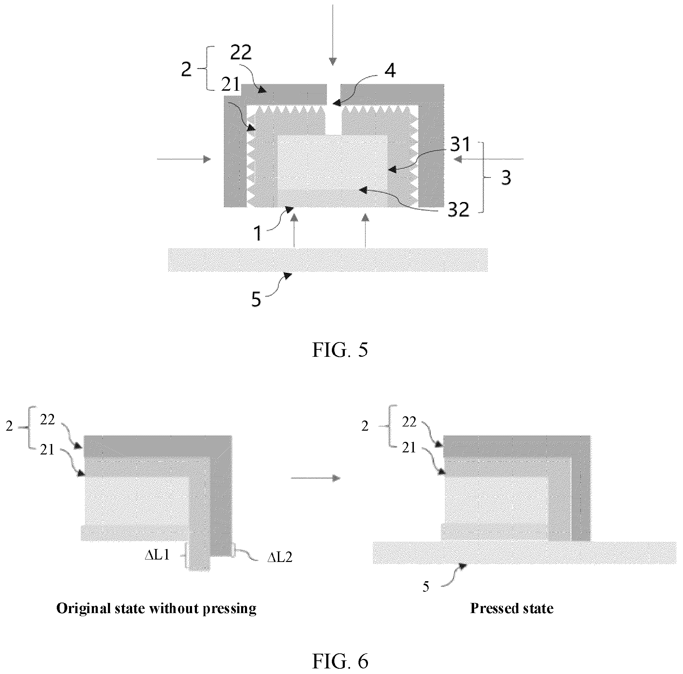

In a possible implementation, a contact surface between the plurality of dielectric layers included in the noise reduction component 2 is a rough surface. The first dielectric layer 21 and the second dielectric layer 22 are used as an example for description. As shown in FIG. 5, the first dielectric layer 21 is not closely attached to the second dielectric layer 22, and a contact surface between the first dielectric layer 21 and the second dielectric layer 22 is a rough surface. Specifically, a surface that is of the first dielectric layer 21 and that is in contact with the second dielectric layer 22 may be a rough surface, or a surface that is of the second dielectric layer 22 and that is in contact with the first dielectric layer 21 may be a rough surface.

Surface roughness may be defined by a spacing between micro textures. In a possible implementation, a spacing between micro textures on the surface that is of the first dielectric layer 21 and that is in contact with the second dielectric layer 22 is greater than a first threshold, or a spacing between micro textures on the surface that is of the second dielectric layer 22 and that is in contact with the first dielectric layer 21 is greater than the first threshold. According to a design requirement of an actual scenario, the first threshold may be 1 mm, 2 mm, 5 mm, or the like.

The contact surface between the first dielectric layer 21 and the second dielectric layer 22 may include various micro textures. For example, the micro texture may be sawtooth-shaped, and a specific shape of the sawtooth may be a triangle, a semicircle, an ellipse, or a trapezoid. This is not limited in this embodiment of this application.

The contact surface between the plurality of dielectric layers of the noise reduction component 2 is set as a rough surface. In this way, an air spacing can be added between the dielectric layers, and an energy loss between the plurality of layers of elastic materials is increased by using the air spacing, to further reduce external noise vibration propagated to a surface of the sound pickup 3. In addition, roughness of a contact surface of the elastic materials is increased, so that vibration generated by friction between the dielectric layers can be reduced, and impact of the plurality of dielectric layers on a sound pickup effect can be reduced.

In a possible implementation, the vibration obtaining component 1 seals the opening end of the first dielectric layer 21 in a manner shown in FIG. 2. That is, a periphery of the third dielectric layer is in close contact with the first dielectric layer 21, to seal the opening end of the first dielectric layer 21. In this case, when the bone conduction microphone is used to obtain vibration on human skin, the end sides of the opening ends of the first dielectric layer 21 and the second dielectric layer 22 are also in contact with user skin.

In a possible implementation, as shown in FIG. 6, an edge that is of the first dielectric layer 21 and that corresponds to the opening end and an edge that is of the second dielectric layer 22 and that corresponds to the opening end exceed the third dielectric layer in a direction perpendicular to the third dielectric layer. Both the first dielectric layer 21 and the second dielectric layer 22 are made of elastic materials. When in contact with human skin, the first dielectric layer 21 and the second dielectric layer 22 undergo elastic deformation corresponding to an elastic modulus due to pressing by the human skin. In this way, the first dielectric layer 21 and the second dielectric layer 22 are more closely attached to the user skin through an acting force of the elastic deformation. This can prevent external noise from being propagated to the sound pickup through a gap between the bone conduction microphone and the user skin, and also prevent noise caused by friction between the bone conduction microphone and a surface of the user skin due to movement of the bone conduction microphone.

A length of the first dielectric layer 21 in the direction perpendicular to the third dielectric layer is referred to as L₁, a length of the second dielectric layer 22 in the direction perpendicular to the third dielectric layer is referred to as L₂, a length by which the edge that is of the first dielectric layer 21 and that corresponds to the opening end exceeds the third dielectric layer in the direction perpendicular to the third dielectric layer is referred to as ΔL₁, and a length by which the edge that is of the second dielectric layer 22 and that corresponds to the opening end exceeds the third dielectric layer in the direction perpendicular to the third dielectric layer is referred to as ΔL₂. An elastic modulus of a material of the first dielectric layer is referred to as E₁, and an elastic modulus of a material of the second dielectric layer is referred to as E₂. In a possible implementation, a ratio of ΔL₁/L₁ to ΔL₂/L₂ is inversely proportional to a ratio of E1 to E2.

When a same magnitude of acting force is applied to two different dielectric layers, a dielectric layer with a larger elastic modulus undergoes greater elastic deformation than a dielectric layer with a smaller elastic modulus. Therefore, the foregoing design can further ensure that each dielectric layer is closely attached to the user skin. This can prevent external noise from being propagated to the sound pickup through a gap between the bone conduction microphone and the user skin, and also prevent noise caused by friction between the bone conduction microphone and a surface of the user skin due to movement of the bone conduction microphone.

It should be understood that FIG. 6 is described by using an example in which the elastic modulus of the material of the first dielectric layer 21 is greater than the elastic modulus of the material of the second dielectric layer 22. Therefore, ΔL₁ is greater than a length of ΔL₂. If an example in which the elastic modulus of the material of the first dielectric layer 21 is less than the elastic modulus of the material of the second dielectric layer 22 is used for description, ΔL₁ is less than a length of ΔL₂.

It should be understood that FIG. 6 and the foregoing embodiments are described by using only an example in which the noise reduction component 2 includes two dielectric layers. However, the noise reduction component 2 may further include more dielectric layers. For setting lengths of the dielectric layers, refer to the foregoing principle. To avoid repetition, details are not described herein again.

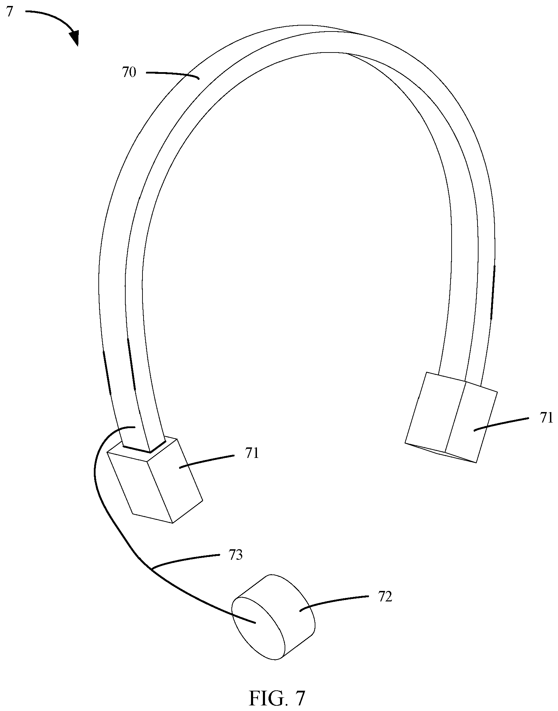

An embodiment of this application further provides a bone conduction headphone. As shown in FIG. 7, a headphone 7 includes a headband 70, a speaker 71 (which may be an air conduction speaker or a bone conduction speaker), a bone conduction microphone 72, and a microphone cable 73. The bone conduction microphone 72 is connected to the headband 70 through the microphone cable 73. It should be understood that the foregoing description of the structure of the headphone and the figure in FIG. 7 is merely an example, and another possible design manner of the bone conduction headphone is possible. A specific design of the bone conduction headphone is not limited in this embodiment of this application. In a possible implementation, some deformation designs may be performed on a structure of the bone conduction headphone according to a requirement. For example, one speaker 71 or two speakers 71 may be disposed according to a requirement. In another possible implementation, another component may further be added to the bone conduction headphone according to a requirement. For example, a sensor configured to capture ambient noise may be added according to a noise reduction requirement.

An embodiment of this application further provides a head-mounted device. The head-mounted device includes a device body and the foregoing bone conduction headphone.

In some examples, the device body is glasses. The glasses may be virtual reality (virtual reality, VR) glasses, or may be augmented reality (augmented reality goggles, AR) glasses.

In some examples, the headband 70 of the headphone is the same as a fastener of the glasses. To be specific, the headband 70 of the headphone is a glasses frame of the glasses, or temples of the glasses frame. Both the bone conduction microphone 72 and the speaker may be connected to the glasses frame (the temples) of the glasses.

Certainly, the headband 70 of the headphone may not be the same as the eyewear frame of the glasses. This is not limited in this embodiment of the present disclosure.

In some other examples, the device body is a helmet. The helmet may be a common helmet, for example, a common safety helmet. The helmet may alternatively be a smart helmet, for example, a smart safety helmet, a helmet-type camera, an evidence-gathering helmet, an intercom helmet, a communication helmet, a thermal imaging helmet, a monocular display smart helmet, or a Bluetooth intercom helmet.

In some examples, the headband 70 of the headphone is fastened to the helmet, and the headphone is integrated with the helmet. In some other examples, the headphone and the helmet may alternatively be two components that are separated from each other. This is not limited in this embodiment of the present disclosure.

An embodiment of this application further provides a call apparatus, including a bone conduction microphone and a transceiver. The transceiver is connected to the bone conduction microphone, and is configured to communicate with an external device held by a communication object. The bone conduction microphone is connected to the transceiver, to input a signal to the transceiver. In a possible implementation, the bone conduction microphone may be connected to the transceiver through a data cable. In another possible implementation, the bone conduction microphone may also be connected to the transceiver in a wireless manner such as Bluetooth.

The foregoing descriptions are merely optional embodiments of the present disclosure, but are not intended to limit the present disclosure. Any modification, equivalent replacement, improvement, or the like made without departing from the principle of the present disclosure should fall within the protection scope of the present disclosure.

## Claims

1. A bone conduction microphone, wherein the bone conduction microphone comprises a sound pickup (3), a vibration obtaining component (1), and a noise reduction component (2);
the noise reduction component (2) comprises at least two dielectric layers, the at least two dielectric layers comprise a first dielectric layer (21) and a second dielectric layer (22), both the first dielectric layer (21) and the second dielectric layer (22) are made of elastic materials, the first dielectric layer (21) is fastened on the sound pickup (3), the first dielectric layer (21) covers another surface (31) of the sound pickup (3) other than a sound pickup surface (32), the first dielectric layer (21) is provided with an opening at an end corresponding to the sound pickup surface (32), the second dielectric layer (22) is fastened on a side that is of the first dielectric layer (21) and that is far away from the sound pickup (3), and the second dielectric layer (22) covers another surface of the first dielectric layer (21) other than the opening end;
a surface that is of the first dielectric layer and that is in contact with the second dielectric layer is a rough surface, or a surface that is of the second dielectric layer and that is in contact with the first dielectric layer is a rough surface;
the vibration obtaining component (1) comprises a third dielectric layer, the third dielectric layer is disposed on a side of the sound pickup (3) close to the sound pickup surface (32), and the opening end of the first dielectric layer (21) is sealed with the third dielectric layer;
the vibration obtaining component (1) is configured to touch a human body to obtain vocal cord vibration; and
the noise reduction component (2) is configured to absorb vibration in a direction of the another surface (31) other than the sound pickup surface (32).

2. The bone conduction microphone according to claim 1, wherein a periphery of the third dielectric layer is in close contact with the first dielectric layer (21) to seal the opening end of the first dielectric layer (21); and
an edge that is of the first dielectric layer (21) and that corresponds to the opening end and an edge that is of the second dielectric layer (22) and that corresponds to the opening end exceed the third dielectric layer in a direction perpendicular to the third dielectric layer.

3. The bone conduction microphone according to claim 1, wherein
a ratio of ΔL₁/L₁ to ΔL₂/L₂ is inversely proportional to a ratio of E₁ to E₂, wherein E₁ is an elastic modulus of the first dielectric layer (21), E₂ is an elastic modulus of the second dielectric layer (22), ΔL₁ is a length by which the edge that is of the first dielectric layer (21) and that corresponds to the opening end exceeds the third dielectric layer in the direction perpendicular to the third dielectric layer, ΔL₂ is a length by which the edge that is of the second dielectric layer (22) and that corresponds to the opening end exceeds the third dielectric layer in the direction perpendicular to the third dielectric layer, L₁ is a total length of the first dielectric layer (21) in the direction perpendicular to the third dielectric layer, and L₂ is a total length of the second dielectric layer (22) in the direction perpendicular to the third dielectric layer.

4. The bone conduction microphone according to any one of claims 1 to 3, wherein a spacing between micro textures on the surface that is of the first dielectric layer (21) and that is in contact with the second dielectric layer (22) is greater than a first threshold, or a spacing between micro textures on the surface that is of the second dielectric layer (22) and that is in contact with the first dielectric layer (21) is greater than the first threshold.

5. The bone conduction microphone according to any one of claims 1 to 4, wherein the noise reduction component (2) comprises a plurality of dielectric layers, and elastic moduli of materials of the plurality of dielectric layers sequentially increase from a direction close to the sound pickup to a direction away from the sound pickup.

6. The bone conduction microphone according to claim 5, wherein an elastic modulus of an outermost dielectric layer in the plurality of dielectric layers is less than a second threshold.

7. The bone conduction microphone according to any one of claims 1 to 6, wherein the first dielectric layer (21) is closely attached to the another surface (31) of the sound pickup (3) other than the sound pickup surface (32).

8. The bone conduction microphone according to any one of claims 1 to 7, wherein the third dielectric layer is closely attached to the sound pickup surface (32).

9. The bone conduction microphone according to any one of claims 1 to 8, wherein the noise reduction component (2) is provided with a lead port (4), and a signal cable of the sound pickup (3) is led out from the lead port (4).

10. The bone conduction microphone according to any one of claims 1 to 9, wherein the sound pickup (3) is a capacitive sensor.

11. A bone conduction headphone, wherein the bone conduction headphone comprises the bone conduction microphone according to any one of claims 1 to 10 and a speaker (71).

12. A head-mounted device, wherein the head-mounted device comprises a device body and the headphone according to claim 11, and the device body comprises glasses or a helmet.

13. A call apparatus, wherein the call apparatus comprises the bone conduction microphone according to any one of claims 1 to 10 and a transceiver, and the transceiver is connected to the bone conduction microphone and communicates with an external device.
